# EUROPEAN PATENT SPECIFICATION

(11) **EP 1 750 335 B1**
(45) Date of publication and mention of the grant of the patent: **03.09.2008**
(21) Application number: 06015388.9
(22) Date of filing: 24.07.2006
(51) Int. Cl.: H01S 5/0683, H01S 5/024, H01S 5/068

(54) **Driving circuit and driving method for laser light source**
Treiberschaltung und Ansteuerverfahren für eine Laserlichtquelle
Circuit de commande et procédé de commande pour une source lumineuse à laser

(30) Priority: 03.08.2005 JP 2005224981
(43) Date of publication of application: 07.02.2007
(73) Proprietor: SHINKO ELECTRIC INDUSTRIES CO., LTD., Nagano-shi, Nagano 381-2287 (JP)
(72) Inventor: Sekigawa, Kazunari, Nagano-shi, Nagano 381-2287 (JP)
(74) Representative: von Hellfeld, Axel

(56) References cited:
- JP-A- 62 155 577
- JP-A- 63 314 877
- JP-A- 2001 216 672
- US-A- 4 930 134
- US-A- 5 680 410

## Description

### BACKGROUND OF THE INVENTION

### 1. Field of the Invention

The present invention relates to a driving circuit and a driving method for a laser light source comprising a laser diode and a photodiode, disposed in close proximity, to receive light emitted from the laser diode and control the intensity of light emission of the laser diode.

### 2. Description of the Related Art

A laser light source (semiconductor laser) constructed from a laser diode (LD) incorporates a photodiode (PD) for receiving light emitted from the laser diode and for controlling the intensity of light emission of the laser diode. As an example of such a laser light source, a laser light source constructed in the form of a module with a laser diode and a photodiode mounted in close proximity to each other is described in Japanese Unexamined Patent Publication NO. 2004-349320. In a laser light source driving circuit, negative feedback control is achieved by using the result of the detection, of the light emission intensity of the laser diode, supplied by the photodiode to thereby maintain the intensity of light emission of the laser diode at a constant level.

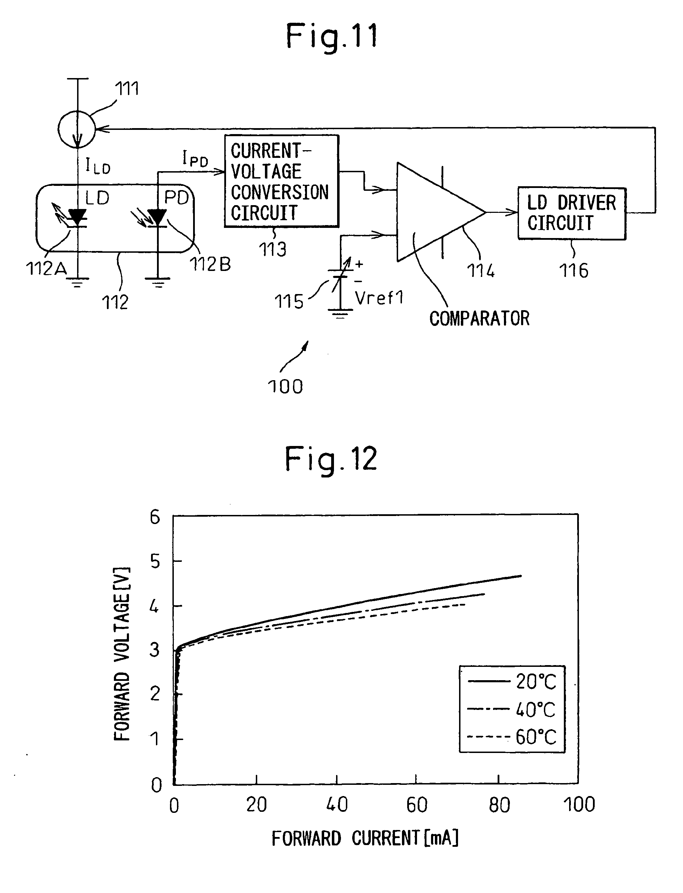

Figure 11 is a circuit diagram showing a conventional driving circuit for a laser light source. It is to be understood that component elements having the same functions are designated by the same reference characters throughout the several drawings given herein.

A laser diode 112A and a photodiode 112B are mounted in close proximity to each other in a module 112, and the laser diode 112A and the photodiode 112B are optically coupled. The laser diode 112A emits light by being supplied with a current I_{LD} from a current source 111. The photodiode 112B receives the light emitted from the laser diode 112A, and outputs a current I_{PD} proportional to the output light power of the laser diode 112A. A current-voltage conversion circuit 113 converts the output current I_{PD} of the photodiode 112B into a voltage for output. As the current-voltage conversion circuit 113 has an extremely low input impedance, the output voltage of the current-voltage conversion circuit 113 varies linearly over a wide range with the output light power of the laser diode 112A. A comparator 114 compares the output voltage of the current-voltage conversion circuit 113 with a reference voltage Vref1 set by a reference voltage setter 115. A LD driver 116, based on the result of the comparison from the comparator 114, controls the current I_{LD} of the current source 111 so that the output voltage of the current-voltage conversion circuit 113 matches the reference voltage Vref1.

In a maskless exposure apparatus which forms interconnection patterns on interconnect substrates by direct exposure, a laser light source such as described above and, among others, a blue violet semiconductor laser is used as the light source.

Figure 12 is a diagram showing the voltage-current characteristics of a conventional blue semiconductor laser. The graph shown here is cited from a data sheet published by Nichia Chemical Industries, and shows the voltage-current characteristics of the blue semiconductor laser (part number: NDHV310APC) manufactured by them. The graph shows the characteristics by taking the operating temperature of the blue semiconductor laser as a parameter. As can be seen from the graph, compared with conventional LEDs, the blue semiconductor laser has a large forward voltage drop and, hence, a large power loss.

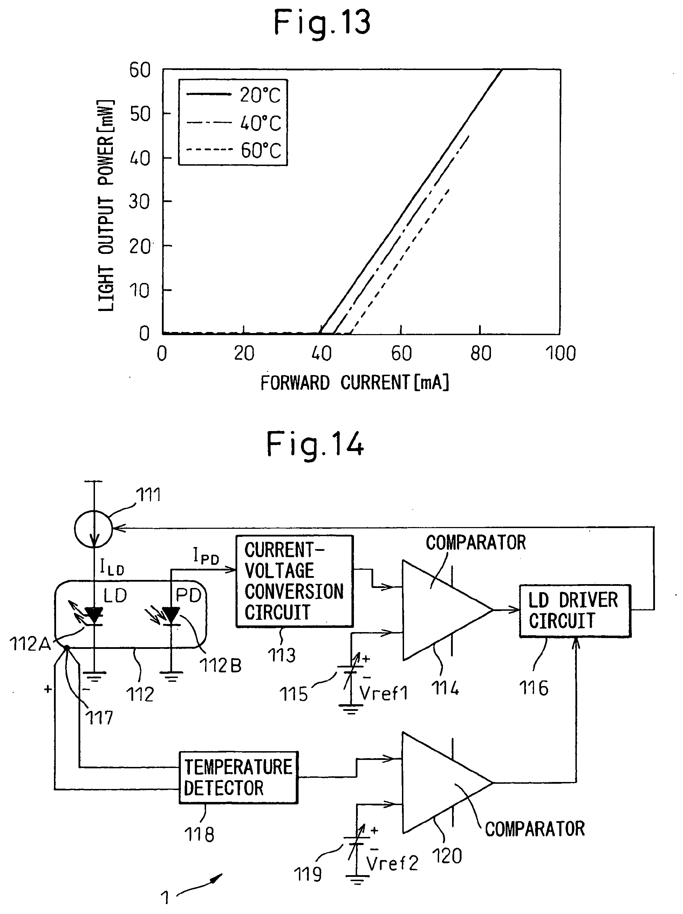

Figure 13 is a diagram showing the light output power versus current characteristics of the conventional blue semiconductor laser. This graph is also cited from a data sheet published by Nichia Chemical Industries, and shows the light output power versus current characteristics of the blue semiconductor laser (part number: NDHV310APC) manufactured by them. The graph shows the characteristics by taking the operating temperature of the blue semiconductor laser as a parameter. As can be seen from the graph, the blue semiconductor laser has the characteristic that, when the driving current is constant, the light output power decreases as the operating temperature of the blue semiconductor laser increases.

In the case of a laser diode that has the characteristic that the power loss is large and the light output power decreases as the operating temperature increases, such as the above blue semiconductor laser, the light output power decreases when the operating temperature of the blue semiconductor laser increases due to the heating associated with power loss.

Here, consider the case where control is performed to maintain the intensity of light emission of the laser diode 112A at a constant level in the driving circuit 100 using negative feedback control such as shown in Figure 11. When the light output power of the laser diode 112A drops due to the heating associated with power loss, the LD driver 116 controls the current source 111 and increases the driving current I_{LD} of the laser diode 112A in order to maintain the light output power at a constant level. When the driving current I_{LD} is increased, the temperature of the laser diode 112A further rises and, because of the heat generated, the light output power further drops. Thereafter, this cycle is repeated, resulting in thermal runaway of the driving circuit 100. The thermal runaway of the driving circuit 100 will eventually lead to destruction of the laser diode 112A.

One method to prevent the destruction of the laser diode due to such thermal runaway is to provide a cooling system that circulates cooling water or gas.

Another method to prevent the destruction of the laser diode due to such thermal runaway is to provide a driving circuit that forcefully stops the supply of the driving current to the laser diode when the temperature becomes abnormally high. Figure 14 is a circuit diagram showing a prior art example of a laser light source driving circuit equipped with the function of preventing thermal runaway. A temperature sensor 117 is disposed near the laser diode 112A in the module 112. A temperature detector 118 converts the output of the temperature sensor 117 into an appropriate voltage level and supplies it to a comparator 120. The comparator 120 compares the output voltage of the temperature detector 118 with a reference voltage Vref2 set by a reference voltage setter 119. The value of the reference voltage Vref2 set by the reference voltage setter 119 corresponds to the maximum allowable operating temperature of the laser diode 112A. If the result of the comparison from the comparator 120 shows that the temperature of the laser diode 112A has exceeded the thus set maximum allowable operating temperature, the LD driver circuit 116 outputs a signal for causing the current source 111 to stop the supply of the current I_{LD}. The remainder of the circuit configuration is the same as the circuit configuration shown in Figure 11 and, therefore, the same parts are designated by the same reference characters and the description of such parts will not be repeated.

As the laser light source and, especially, the blue semiconductor laser, is very expensive, it is not desirable to let the driving circuit enter thermal runaway and destroy the laser diode. In particular, in the case of a maskless exposure apparatus which uses a large number of laser light sources as its light source, the resulting economic loss would be enormous. Accordingly, preventing laser diode destruction due to thermal runaway is a critical issue not only from the standpoint of ensuring stable operation of the maskless exposure apparatus but also from the standpoint of avoiding unnecessary economic loss.

However, cooling systems that circulate cooling water or gas, such as described above, are mostly mechanical systems, and their response is slow compared with electrical systems. Further, such cooling systems are prone to mechanical failures, such as filter clogging and pipe breakage, and the maintenance for preventing such failures can be laborious.

On the other hand, in the driving circuit that uses a temperature sensor and forcefully stops the supply of the driving current to the laser diode when the temperature rises abnormally high, the temperature sensor and its control system must be provided for each laser diode. Installing a temperature sensor near the laser diode in the module is not desirable in terms of cost and space. Furthermore, the circuit configuration of the entire apparatus becomes complex.

Document JP 62 155577-A discloses a semiconductor laser element driven by a semiconductor laser controlling circuit. A diode element is arranged in the vicinity of the laser element in a semiconductor laser case. The diode element generates a forward direction voltage, which is processed and outputted to the semiconductor laser controlling circuit as a signal to control the light output of the laser regarding an excessive temperature rise.

Document US 4 930 134-A discloses a laser and a photodiode mounted on a common supportive base. The photodiode is used to provide a controllable laser output beam by setting up an optical feedback loop. Alternatively, a monitor photodiode can be used to measure the temperature of the laser.

In view of the above problems, it is an object of the present invention to provide a driving circuit and a driving method for a laser light source wherein the function of preventing laser diode destruction due to a rise in operating temperature is implemented with high accuracy and with simple structure.

### SUMMARY OF THE INVENTION

To achieve the above object, according to the present invention, there is provided a driving circuit for a laser light source comprising a laser diode and a photodiode as defined in the independent claims. Preferred embodiments are defined by the dependent claims.

Document JP 2001216672 discloses a laser diode and a photodiode mounted close to the laser diode back emission facet to provide temperature measurement of the laser diode and to suitch off the supply of current to the laser diode if the temperature exceeds a predetermined value.

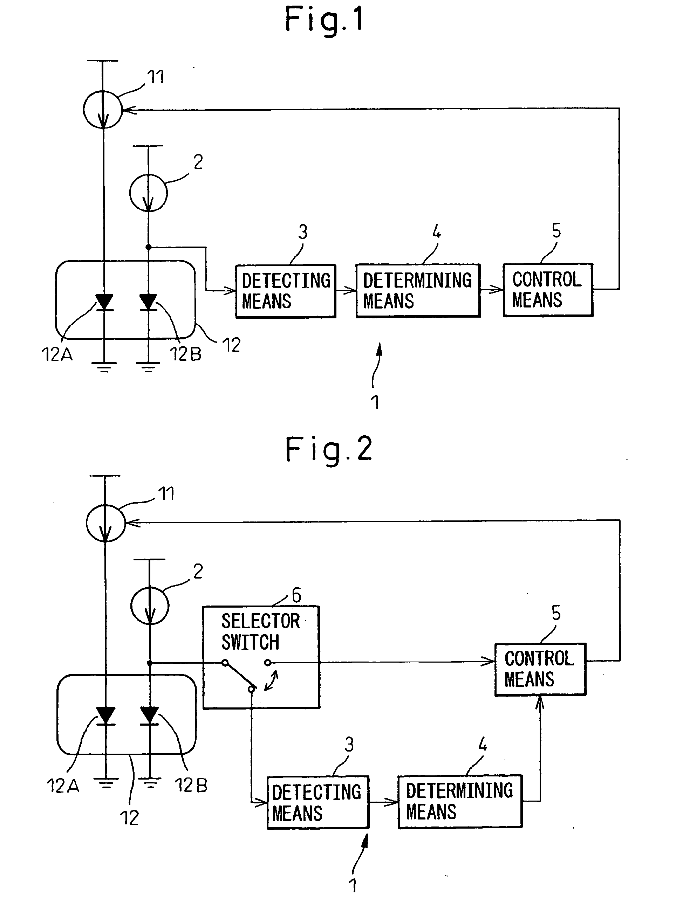

Figure 1 is a block diagram showing the basic functional configuration of the laser light source driving circuit according to an example. A laser diode 12A and a photodiode 12B are mounted in close proximity to each other in a module 12, and the laser diode 12A and the photodiode 12B are coupled not only optically but also thermally. The laser diode 12A emits light by being supplied with a current from a current source 11. The driving circuit 1 of the present invention comprises: a constant-current source 2 which supplies a current to the photodiode 12B so as to forward-bias the photodiode 12B; detecting means 3 for detecting the forward voltage of the photodiode 12B; determining means 4 for determining whether or not the forward voltage detected by the detecting means 3 is smaller than a predetermined reference voltage; and control means 5 for controlling the supply of current from the current source 11 to the laser diode 12A. When the determining means 4 determines that the forward voltage is smaller than the predetermined reference voltage, the control means 5 controls the current source 11 so as to stop the supply of current to the laser diode 12A.

The driving circuit of the present invention has two operation modes, a temperature measuring mode and a light power measuring mode. Switching between the temperature measuring mode and the light power measuring mode is effected by means of a selector switch. Figure 2 is a block diagram showing the basic functional configuration of the laser light source driving circuit having the temperature measuring mode and the light power measuring mode according to the present invention. The driving circuit 1 comprises: selector switch 6 for effecting switching between the light power measuring mode and the temperature measuring mode; constant-current source 2 which, in the temperature measuring mode, supplies a current to the photodiode 12B so as to forward-bias the photodiode 12B; detecting means 3 for detecting the forward voltage of the photodiode 12B in the temperature measuring mode; determining means 4 for determining whether or not the forward voltage detected by the detecting means 3 is smaller than a predetermined reference voltage; and control means 5 for controlling the supply of current from the current source 11 to the laser diode 12A. In the light power measuring mode, the control means 5 controls the supply of current from the current source 11 to the laser diode 12A in order to control the intensity of light emission of the laser diode 12A based on the current that the photodiode 12B produces by receiving the light emitted from the laser diode 12A. On the other hand, in the temperature measuring mode, when the determining means 4 determines that the forward voltage is smaller than the reference voltage, the control means 5 controls the current source 11 so as to stop the supply of current to the laser diode 12A.

The reason that the photodiode is forward-biased will be described below.

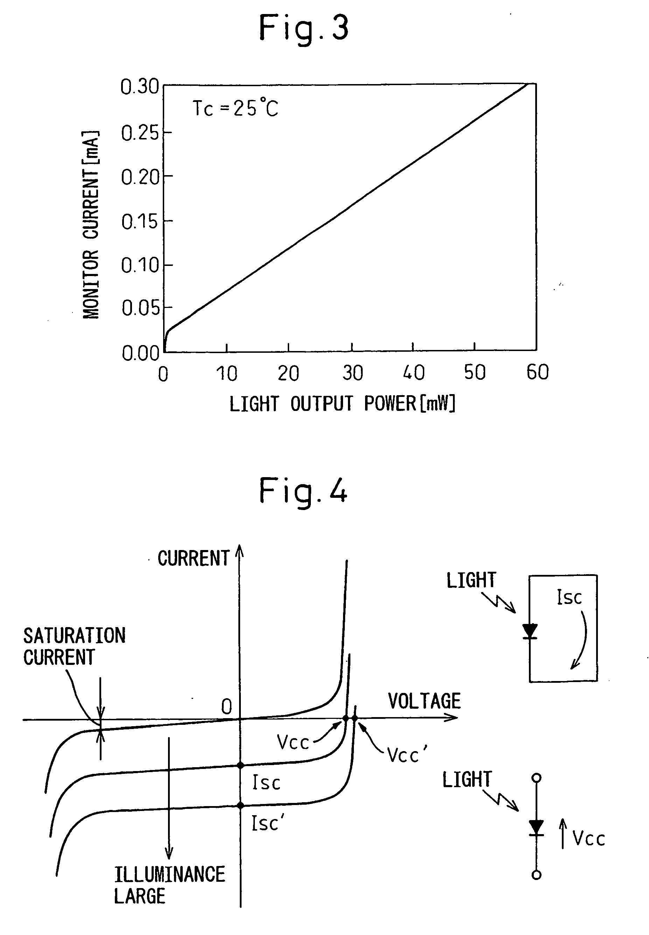

Figure 3 is a diagram showing the monitor current versus light output power characteristics of a conventional blue semiconductor laser. The graph shown here is cited from a data sheet published by Nichia Chemical Industries, and shows the monitor current versus light output power characteristics of a blue semiconductor laser (part number: NDHV310APC) manufactured by them. The monitor current refers to the current that the photodiode produces by receiving the light emitted from the laser diode. This graph shows the characteristic only for the case where the operating temperature T_{C} is 25°C, but it is well known that, generally, the monitor current versus light output power characteristic is extremely stable to temperature variations.

Figure 4 is a diagram showing the voltage-current characteristics of a conventional photodiode. The graph shown here is cited from a technical document "Si PD technical information.pdf" published by Hamamatsu Photonics KK, and shows the current-voltage characteristics under forward- and reverse-biased conditions. In a laser light source module, it is common to use a PN-junction photodiode made of silicon. That is, when the photodiode is forward-biased, it exhibits current-voltage characteristics comparable to those of conventional silicon rectifying diodes. Generally, when a forward current flows across a PN junction, the resulting forward voltage is proportional to the temperature of the PN junction and the magnitude of the forward current. In particular, in the case of a PN junction of silicon, it is known that when the forward current is constant, the forward voltage decreases by about 2 mV to 2.5 mV as the temperature of the PN junction rises by 1°C. Further, the effect of the forward current on the forward voltage is logarithmic. Accordingly, when the photodiode is forcefully forward-biased by using an external constant-current source, any change in the temperature of the photodiode can be detected by observing a change in the forward voltage of the photodiode.

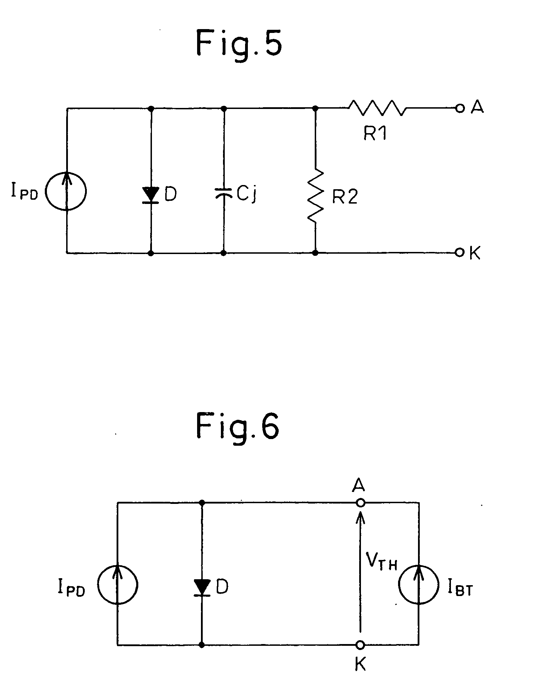

Figure 5 is a circuit diagram showing an equivalent circuit of a conventional photodiode. In the figure, I_{PD} designates the current (the light output power of a laser diode) that the photodiode produces by receiving the light emitted from the laser diode. D indicates a PN-junction diode. Further, Cⱼ indicates the junction capacitance of the PN junction, which is negligible for direct current. R2 is a leakage resistance component, which is actually large enough to be disregarded. R1 is a contact resistance component, which is actually negligibly small.

From Figures 3 and 4, it can be seen that the current (I_{SC} in Figure 4) that the photodiode produces by receiving the light emitted from the laser diode is proportional to the light output power of the laser diode (that is, it is also proportional to the illuminance on the photodiode), but the effect that the illuminance has on the decrease of the forward voltage is small. That is, when the current that the external constant-current source supplies to forcefully forward-bias the photodiode is made sufficiently larger than the current that the photodiode produces by receiving the light emitted from the laser diode, then if the light emitted from the laser diode is incident on the photodiode, its effect on the forward voltage of the photodiode is negligibly small. Figure 6 is a circuit diagram showing an equivalent circuit when the conventional photodiode is forcefully forward-biased using an external constant-current source. When the current that the external constant-current source I_{BT} supplies to forcefully forward-bias the photodiode is made sufficiently larger than the current I_{PD} that the photodiode produces by receiving the light emitted from the laser diode, then, if the light emitted from the laser diode is incident on the photodiode, its effect on the forward voltage V_{TH} is negligibly small, and any change in the temperature of the photodiode can be detected by measuring a change in the forward voltage of the photodiode. As earlier described, as the photodiode and the laser diode are disposed very close to each other in the module, and are therefore well coupled thermally, a change in the temperature of the photodiode can be regarded as a change in the temperature of the laser diode.

The present invention utilizes the above characteristics of the photodiode mounted in the laser light source module; that is, the most important feature of the invention is that the function of a temperature sensor is incorporated into the photodiode itself by making provisions to forward-bias the photodiode with a current sufficiently larger than the current that the photodiode produces by receiving the light emitted from the laser diode. When the forward voltage of the photodiode being supplied with the current for forward biasing is smaller than a predetermined reference voltage, the supply of current to the laser diode is stopped by determining that the temperature has exceeded the maximum allowable operating temperature. Of course, the photodiode also has the function of a light output power sensor to receive the light emitted from the laser diode. Therefore, it is preferable to use the photodiode by appropriately switching its function between the light output power sensor and the temperature sensor.

### BRIEF DESCRIPTION OF THE DRAWINGS

The present invention will be more clearly understood from the description as set below with reference to the accompanying drawings, wherein:
Figure 1 is a block diagram showing the basic functional configuration of a laser light source driving circuit according to an example;
Figure 2 is a block diagram showing the basic functional configuration of a laser light source driving circuit having a temperature measuring mode and a light power measuring mode according to the present invention;
Figure 3 is a diagram showing the monitor current versus light output power characteristics of a conventional blue semiconductor laser;
Figure 4 is a diagram showing the voltage-current characteristics of a conventional photodiode;
Figure 5 is a circuit diagram showing an equivalent circuit of a conventional photodiode;
Figure 6 is a circuit diagram showing an equivalent circuit when the conventional photodiode is forcefully forward-biased using an external constant-current source;
Figure 7 is a circuit diagram showing a laser light source driving circuit according to a first embodiment of the present invention;
Figure 8 is a state transition diagram for explaining the mode switching operation of the laser light source driving circuit according to the first embodiment of the present invention;
Figure 9 is a diagram for explaining the relationships of various reference voltages relative to the light power measuring mode and temperature measuring mode in the first embodiment of the present invention;
Figure 10 is a circuit diagram showing a laser light source driving circuit according to a second embodiment of the present invention;
Figure 11 is a circuit diagram showing a conventional driving circuit for a laser light source;
Figure 12 is a diagram showing the voltage-current characteristics of a conventional blue semiconductor laser;
Figure 13 is a diagram showing the light output power versus current characteristics of the conventional blue semiconductor laser; and
Figure 14 is a circuit diagram showing a prior art example of a laser light source driving circuit equipped with the function of preventing thermal runaway.

### DESCRIPTION OF THE PREFERRED EMBODIMENTS

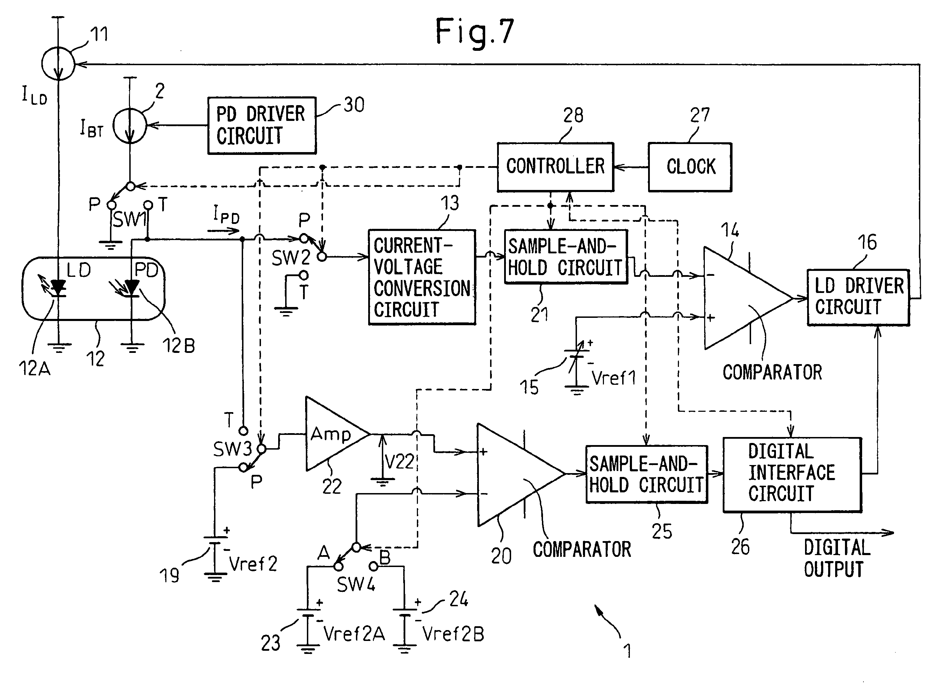

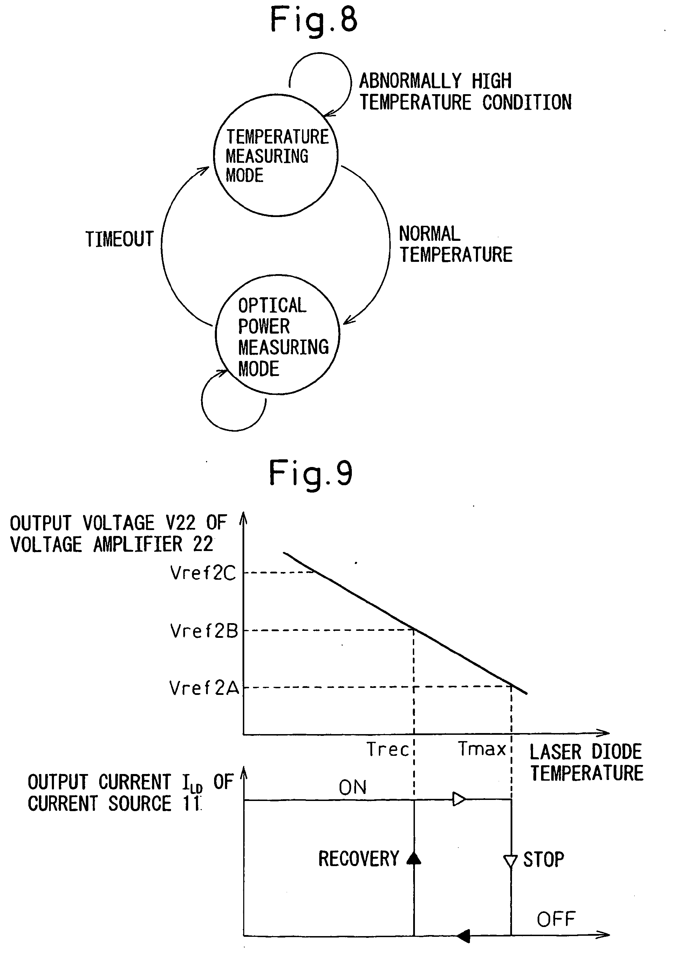

Figure 7 is a circuit diagram showing a laser light source driving circuit according to a first embodiment of the present invention. Figure 8 is a state transition diagram for explaining the mode switching operation of the laser light source driving circuit according to the first embodiment of the present invention.

A laser diode 12A and a photodiode 12B are mounted in close proximity to each other in a module 12, and the laser diode 12A and the photodiode 12B are coupled not only optically but also thermally. The laser diode 12A emits light by being supplied with a current I_{LD} from a current source 11. The photodiode 12B outputs a current I_{PD} proportional to the output light power of the laser diode 12A.

The driving circuit 1 according to the present invention has two operation modes, a temperature measuring mode and a light power measuring mode. Switches SW1, SW2, and SW3 are provided as the selector switch 6 described with reference to Figure 1 for effecting switching between the temperature measuring mode and the light power measuring mode. The switches SW1, SW2, and SW3 each have contacts P and T. The contact P is selected for the light power measuring mode, while the contact T is selected for the temperature measuring mode. Figure 7 shows as an example the case where the driving circuit 1 is in the light power measuring mode with all the switches SW1, SW2, and SW3 connected to the contacts P. Further, in Figure 7, dashed lines indicate digital control signal lines. Digital control signals are processed in synchronism with the clock signal generated by a clock 27.

First, the circuit system that operates primarily in the light power measuring mode will be described.

In the light power measuring mode, the switches SW1, SW2, and SW3 are connected to their respective contacts P.

The laser diode 12A emits light by being supplied with the current I_{LD} from the current source 11. The photodiode 12B outputs the current I_{PD} which is proportional to the output light power of the laser diode 12A.

A PD driver circuit 30 controls a constant-current source 2 which is a current source for forcefully forward-biasing the photodiode 12B. The constant-current source 2 outputs a current I_{BT}. In the light power measuring mode, as the switch SW1 is connected to the contact P, the current I_{BT} output from the constant-current source 2 flows to ground, and no current flows to the photodiode 12B.

A current-voltage conversion circuit 13 converts the current I_{PD} of the photodiode 12B, supplied via the contact P of the switch SW2, into a voltage for output. As the current-voltage conversion circuit 13 has an extremely low input impedance, the output voltage of the current-voltage conversion circuit 13 varies linearly over a wide range with the output light power of the laser diode 12A.

A sample-and-hold circuit 21 samples the output voltage of the current-voltage conversion circuit 13 at predetermined intervals of time and holds the sampled value.

A comparator 14 compares the voltage held by the sample-and-hold circuit 21 with a reference voltage Vref1 set by a reference voltage setter 15. An LD driver 16, based on the result of the comparison from the comparator 14, controls the current I_{LD} of the current source 11 so that the voltage held by the sample-and-hold circuit 21 matches the reference voltage Vref1.

A voltage amplifier 22 is an amplifier for amplifying the voltage developed between the anode and cathode of the photodiode 12B to a suitable level. In the light power measuring mode, as the switch SW3 is connected to the contact P, a reference voltage Vref2 set by a reference voltage setter 19, not the voltage developed between the anode and cathode of the photodiode 12B, is applied to the input terminal of the voltage amplifier 22. The output voltage V22 of the voltage amplifier 22 is given by Av x Vref2, where Av is the voltage amplification factor (gain). Here, the output voltage is defined as Av x Vref2 = Vref2C. The reference voltage Vref2C is a voltage representing a suitable temperature during the normal operation of the laser diode 12A, and its specific magnitude will be described later.

A comparator 20 compares the output voltage V22 of the voltage amplifier 22 with a reference voltage Vref2A or Vref2B supplied via a contact A or contact B of a switch SW4. The reference voltage Vref2A is set by a reference voltage setter 23, while the reference voltage Vref2B is set by a reference voltage setter 24. It is assumed here that the relation "Vref2C > Vref2B > Vref2A" always holds. The reference voltage Vref2A is a voltage corresponding to the maximum allowable operating temperature (Tmax) of the laser diode 12A, and its details will be described later. On the other hand, the reference voltage Vref2B is a voltage corresponding to the recovery temperature (Trec) of the laser diode 12A, and its details will be described later. The reference voltage Vref2C is a voltage representing the temperature during the normal operation of the laser diode 12A, and any suitable value can be chosen as long as the value satisfies the relation "Vref2C > Vref2B".

In the power measuring mode, when the laser diode 12A is not in an abnormally high temperature condition, the switch SW4 is always connected to the contact A, and as a result, in this case, the output of the comparator 20 is always high.

Next, the circuit system that operates primarily in the temperature measuring mode will be described.

As shown in Figure 8, when a prescribed time has elapsed in the light power measuring mode after effecting switching from the temperature measuring mode to the light power measuring mode, that is, when a timeout has occurred, the operation mode switches from the light power measuring mode to the temperature measuring mode.

In the temperature measuring mode, the switches SW1, SW2, and SW3 are connected to their respective contacts T.

In the temperature measuring mode also, as long as the laser diode 12A is not in an abnormally high temperature condition, the current source 11 continues to supply the current I_{LD} to the laser diode 12A, causing the laser diode 12A to emit light. The photodiode 12B receives the light emitted from the laser diode 12A, and outputs the current I_{PD} which is proportional to the output light power of the laser diode 12A.

On the other hand, as the switch SW1 is connected to the contact T, the current I_{BT} output from the constant-current source 2 flows to the photodiode 12B. As a result, the photodiode 12B is forcefully forward-biased.

As the switch SW2 is connected to the contact T, the input current to the current-voltage conversion circuit 13 is zero. Accordingly, the current-voltage conversion circuit 13 does not output a voltage. However, the sample-and-hold circuit 21 holds the voltage sampled in the power measuring mode just before switching was effected from the power measuring mode to the temperature measuring mode; as a result, the comparator 14 and the LD driver circuit 16 continue to operate in the power measuring mode, so that the current I_{LD} continues to flow to the laser diode 12A.

As previously described, as the current I_{BT} that the constant-current source 2 supplies, to forcefully forward-bias the photodiode 12B, is sufficiently larger than the current I_{PD} that the photodiode produces by receiving the light emitted from the laser diode 12A, if the light emitted from the laser diode 12A is incident on the photodiode 12B, its effect on the forward voltage of the photodiode 12B is negligibly small, and a change in the temperature of the photodiode 12B causes a corresponding change in the forward voltage of the photodiode. Further, as the photodiode 12B and the laser diode 12A are disposed very close to each other in the module 12, and are, therefore, well coupled thermally, a change in the temperature of the photodiode 12B can be regarded as a change in the temperature of the laser diode 12A.

As the switch SW3 is connected to the contact T, the voltage developed between the anode and cathode of the photodiode 12B is applied via the contact T of the switch SW3 to the input terminal of the voltage amplifier 22.

The voltage amplifier 22 amplifies the voltage developed between the anode and cathode of the photodiode 12B, to a suitable level.

The comparator 20 compares the output voltage V22 of the voltage amplifier 22 with the reference voltage Vref2A or Vref2B supplied via the contact A or contact B of the switch SW4. Here, if the temperature of the laser diode 12A has been within a normal temperature range until just before that time, the switch SW4 should remain connected to the contact A; therefore, in this case, the comparator 20 compares the output voltage V22 of the voltage amplifier 22 with the reference voltage Vref2A supplied via the contact A.

Here, consider the case where the output voltage V22 of the voltage amplifier 22 drops below the reference voltage Vref2A which is a voltage corresponding to the maximum allowable operating temperature (Tmax) of the laser diode 12A. In this case, as the output voltage V22 of the voltage amplifier 22 is smaller than the reference voltage Vref2A, the output of the comparator 20 changes from high to low. As earlier described, the output voltage V22 of the voltage amplifier 22 being smaller than the reference voltage Vref2A means that the laser diode 12A is in an abnormally high temperature condition. That is, when the output of the comparator 20 changes from high to low, this means that the temperature of the laser diode 12A has risen to an abnormally high level.

A sample-and-hold circuit 25 samples the output voltage of the comparator 20 at predetermined intervals of time and holds the sampled value. The output of the sample-and-hold circuit 25 is supplied to a digital interface circuit 26.

Upon detecting that the temperature of the laser diode 12A has risen to an abnormally high level, the digital interface circuit 26 sends a signal to the LD driver circuit 16 which, in response, controls the current source 11 so as to stop the supply of the current I_{LD} to the laser diode 12A.

While controlling the current source 11 in this way, the digital interface circuit 26 also sends a signal to a controller 28 which, in response, controls the switch SW4 to switch from the contact A to the contact B. As a result, the comparator 20 compares the output voltage V22 of the voltage amplifier 22 with the reference voltage Vref2B supplied via the contact B. The reference voltage Vref2B is a voltage corresponding to the recovery temperature (Trec) of the laser diode 12A. Here, since the relation "Vref2B > Vref2A" always holds, as earlier described, and since the laser diode 12A is in an abnormally high temperature condition, it follows that the relation "Vref2A > V22" and hence the relation "Vref2B > Vref2A > V22" holds; as a result, the potential difference between the two inputs to the comparator 20 further increases. Accordingly, if the output voltage V22 of the voltage amplifier 22 varies somewhat, since the magnitude relationship between the reference voltage Vref2B and the voltage V22 is retained, the output of the comparator 20 remains low.

For some time after stopping the supply of the current I_{LD} from the current source 11 to the laser diode 12A, the driving circuit 1 stays in the temperature measuring mode. That is, as shown in Figure 8, the temperature measuring mode is maintained as long as the forward voltage of the photodiode 12B in the temperature measuring mode is smaller than the reference voltage Vref2B which is a voltage corresponding to the recovery temperature (Trec) of the laser diode 12A.

When a certain amount of time has elapsed after stopping the supply of the current I_{LD} from the current source 11 to the laser diode 12A, the temperature of the laser diode 12A begins to gradually drop. As the photodiode 12B and the laser diode 12A are disposed very close to each other in the module 12, and are therefore well coupled thermally, as earlier described, the temperature of the photodiode 12B also gradually drops, as a result of which the output voltage V22 of the voltage amplifier 22 gradually increases. When the temperature of the laser diode 12A drops below the recovery temperature (Trec), the output voltage V22 of the voltage amplifier 22 becomes larger than the reference voltage Vref2B corresponding to the recovery temperature (Trec) of the laser diode 12A. As a result, the output of the comparator 20 changes from low to high. As earlier described, the output voltage V22 of the voltage amplifier 22 being larger than "the reference voltage Vref2B which is larger than the reference voltage Vref2A" means that the laser diode 12A has recovered from the abnormally high temperature condition and the temperature has dropped at least to below the recovery temperature (Trec).

The sample-and-hold circuit 25 samples the output voltage of the comparator 20 at predetermined intervals of time and holds the sampled value, and the output of the sample-and-hold circuit 25 is supplied to the digital interface circuit 26.

Upon detecting that the laser diode 12A has recovered from the abnormally high temperature condition and the temperature has dropped at least to below the recovery temperature (Trec), the digital interface circuit 26 sends a signal to the LD driver circuit 16 which, in response, controls the current source 11 so as to resume the supply of the current I_{LD} to the laser diode 12A.

While controlling the current source 11 in this way, the digital interface circuit 26 also sends a signal to the controller 28. In response, the controller 28 controls the switches SW1, SW2, and SW3 to switch from the contact T to the contact P, while also controlling the switch SW4 to switch from the contact B to the contact A. As a result, the comparator 20 compares the output voltage V22 of the voltage amplifier 22 with the reference voltage Vref2A supplied via the contact A. Here, as the relation "Vref2B > Vref2A" always holds, as earlier described, and as the laser diode 12A is in the normal temperature condition, it follows that the relation "V22 > Vref2B" and hence the relation "Vref22 > Vref2B > Vref2A " holds; as a result, the potential difference between the two inputs to the comparator 20 further increases. Accordingly, if the output voltage V22 of the voltage amplifier 22 varies somewhat, because the magnitude relationship between the reference voltage Vref2A and the voltage V22 is retained, the output of the comparator 20 remains high.

That is, as shown in Figure 8, when the forward voltage of the photodiode 12B in the temperature measuring mode has exceeded "the reference voltage Vref2B corresponding to the recovery temperature (Trec) of the laser diode 12A" which is larger than "the reference voltage Vref2A corresponding to the maximum allowable operating temperature (Tmax) of the laser diode 12A", the operation mode switches from the temperature measuring mode to the light power measuring mode.

Thereafter, the operation mode of the driving circuit 1 alternates cyclically between the light power measuring mode and the temperature measuring mode. Here, the digital interface circuit 26 may be configured to digitally output data concerning the detected temperature of the laser diode 12A.

The following summarizes the relationships of the various reference voltages relative to the light power measuring mode and temperature measuring mode in the first embodiment of the present invention. Figure 9 is a diagram for explaining the relationships of the various reference voltages relative to the light power measuring mode and temperature measuring mode in the first embodiment of the present invention.

When the laser diode 12A in Figure 7 is in the normal temperature range, max allowable operating Tmax, the driving circuit 1 operates in the light power measuring mode and the current source 11 supplies the current I_{LD} to the laser diode 12A. At this time, the output voltage V22 of the voltage amplifier 22 is at Vref2C (where Vref2C > Vref2B > Vref2A) as earlier described. In the present embodiment, the operation mode automatically switches from the light power measuring mode to the temperature measuring mode when a prescribed time has elapsed after effecting switching from the temperature measuring mode to the light power measuring mode. As long as the laser diode 12A is operating in the normal temperature range, the operation mode automatically switches from the light power measuring mode to the temperature measuring mode when the prescribed time has elapsed. When the temperature measuring mode is entered, the measuring of the temperature of the laser diode 12A (in other words, the temperature of the photodiode 12B) is started. If it is detected at this time that the laser diode 12A is not in an abnormally high temperature condition, the driving circuit 1 switches from the temperature measuring mode back to the light power measuring mode.

As the temperature of the laser diode 12A rises, the output voltage V22 of the voltage amplifier 22 gradually decreases. When the output voltage V22 of the voltage amplifier 22 drops below the reference voltage Vref2A which is a voltage corresponding to the maximum allowable operating temperature (Tmax) of the laser diode 12A, the current source 11 stops the supply of the current I_{LD} to the laser diode 12A, and the temperature measuring mode is entered. As long as the output voltage V22 of the voltage amplifier 22 stays below the reference voltage Vref2B corresponding to the recovery temperature (Trec) of the laser diode 12A, the supply of the current I_{LD} to the laser diode 12A is stopped, and the driving circuit 1 continues to operate in the temperature measuring mode.

When a certain amount of time has elapsed after stopping the supply of the current I_{LD} from the current source 11 to the laser diode 12A, the temperature of the laser diode 12A begins to drop. As a result, the output voltage V22 of the voltage amplifier 22 gradually increases. When the output voltage V22 of the voltage amplifier 22 becomes larger than the reference voltage Vref2B which is a voltage corresponding to the recovery temperature (Trec) of the laser diode 12A, and as this means that the temperature of the laser diode 12A has dropped below the recovery temperature (Trec), the current source 11 resumes supplying the current I_{LD} to the laser diode 12A and the driving circuit 1 enters the light power measuring mode.

Thereafter, the operation mode of the driving circuit 1 alternates cyclically between the light power measuring mode and the temperature measuring mode.

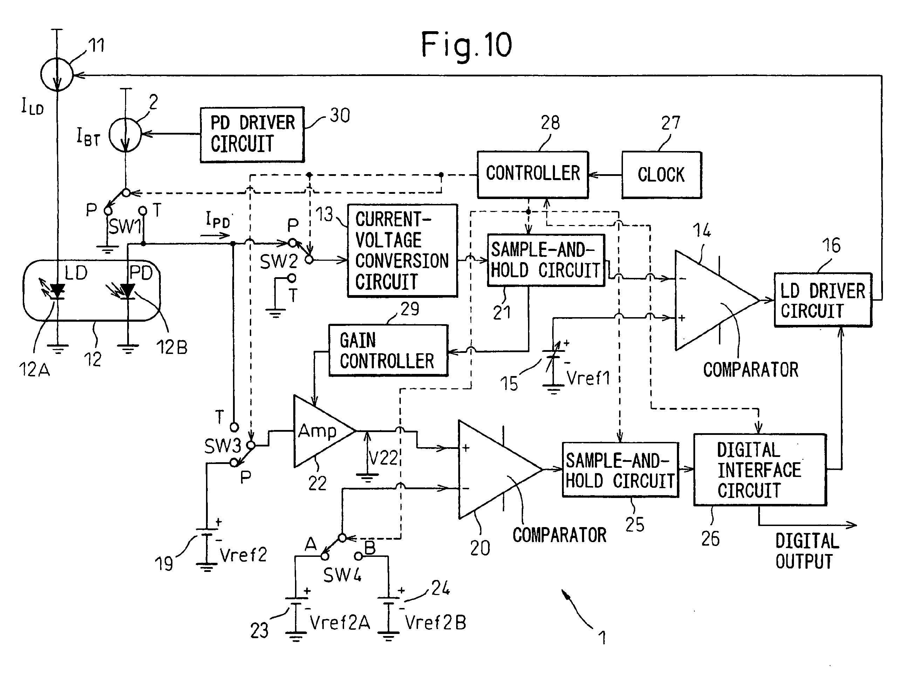

In the first embodiment of the invention described above, as the current I_{BT} that the constant-current source 2 supplies to forcefully forward-bias the photodiode 12B is sufficiently larger than the current I_{PD} that the photodiode 12B produces by receiving the light emitted from the laser diode 12A, a convention has been adopted that, if the light emitted from the laser diode 12A is incident on the photodiode 12B, its effect on the forward voltage of the photodiode 12B can be approximated as being negligibly small. Such an approximation will suffice for the purpose of preventing destruction of the laser diode 12A in an abnormally high temperature condition. By contrast, in a second embodiment of the present invention, provisions are made to detect the temperature of the laser diode 12A with higher accuracy. Figure 10 is a circuit diagram showing a laser light source driving circuit according to the second embodiment of the present invention.

The driving circuit 1 according to the second embodiment of the present invention differs from the driving circuit 1 shown in Figure 7 by the inclusion of a gain controller 29. The gain controller 29 controls the voltage amplification factor (gain) of the voltage amplifier 22. The remainder of the circuit configuration is the same as the circuit configuration shown in Figure 7; therefore, the same parts are designated by the same reference characters, and a description of such parts will not be repeated.

In the temperature measuring mode, the sum of the current I_{PD} that the photodiode 12B produces by receiving the light emitted from the laser diode 12A and the current I_{BT} that the constant-current source 2 supplies to forcefully forward-bias the photodiode 12B flows through the diode D shown in the equivalent circuit of Figure 6 (which models the PN junction of the photodiode 12B). That is, in the foregoing first embodiment, as the change in the temperature of the photodiode 12B (i.e., the change in the temperature of the laser diode 12A disposed in close proximity to the photodiode 12B) is detected based on the forward voltage occurring due to the flowing of the sum current, the current I_{PD} that the photodiode 12B produces by receiving the light emitted from the laser diode 12A constitutes an error component in the temperature detection. In contrast, in the second embodiment of the present invention, the gain controller 29 adjusts the voltage amplification factor of the voltage amplifier 22 in such a manner as to cancel out the error component. As described above, in the temperature measuring mode, the voltage corresponding to the sum of the current I_{PD} that the photodiode 12B produces by receiving the light emitted from the laser diode 12A and the current I_{BT} that the constant-current source 2 supplies to forcefully forward-bias the photodiode 12B is input to the voltage amplifier 22. To achieve higher-accuracy temperature detection, the gain controller 29 sets the voltage amplification factor of the voltage amplifier 22 somewhat lower than the initially set value by using information about the voltage proportional to I_{PD} in the immediately preceding light power measuring mode held by the sample-and-hold circuit 21.

The present invention can be applied to a driving circuit and a driving method for a laser light source comprising a laser diode and a photodiode disposed in close proximity to receive light emitted from the laser diode and control the intensity of light emission of the laser diode.

According to the present invention, the function of preventing laser diode destruction due to a rise in operating temperature can be implemented with high accuracy and with a simple structure in the laser light source driving circuit. In the present invention, as the photodiode disposed very close to the laser diode is also used as the temperature sensor, the temperature detection accuracy is high and the response is fast. That is, as an abnormally high temperature condition of the laser diode can be detected nearly in real time, the laser diode can be reliably protected against thermal destruction. Furthermore, the apparatus construction can be simplified as there is no need to provide a separate temperature sensor.

The present invention is particularly effective in applications where a large number of laser light sources are used as the light source as in a maskless exposure apparatus. In such a maskless exposure apparatus, a surface light source for illuminating an article to be exposed is constructed by arranging a plurality of laser light sources.

## Claims

1. A driving circuit (1) for a laser light source comprising a laser diode (12A) and a photodiode (12B) disposed In close proximity to said laser diode (12A) to receive light emitted from said laser diode (12A) and to control the intensity of light emission of said laser diode (12A), said driving circuit (1) comprising: control means (5) for controlling the supply of a current to said laser diode (12A);
a selector switch (6) for effecting switching between a light power measuring mode and a temperature measuring mode;
a constant-current source (2) which, in said temperature measuring mode, supplies a current to said photodiode (12B) so as to forward-bias said photodiode (12B);
detecting means (3) for detecting forward voltage of said photodiode (12B) in said temperature measuring mode;
first determining means for determining whether or not said forward voltage detected by said detecting means (3) is smaller than a first reference voltage; in said temperature measuring wherein
in said light power measuring mode, said control means (5) controls the intensity of light emission of said laser diode (12A) based on a current that said photodiode (12B) produces by receiving the light emitted from said laser diode (12A), in said temperature measuring mode, when said first determining means determines that said forward voltage is smaller than said first reference voltage, said control means (5) performs control so as to stop the supply of said current to said laser diode (12A), **characterized in that**, in said temperature measuring mode; when said first determining means determines that said forward voltage is not smaller than said first reference voltage, said control means (5) performs control so as to hold the supply of said current to said laser diode (12A) just before switching was effected from the power measuring mode to the temperature measuring mode.

2. A driving circuit for a laser light source as claimed in claim 1, wherein the current that said constant-current source (2) supplies to said photodiode (12B) is sufficiently larger than the current that said photodiode (12B) produces by receiving the light emitted from said laser diode (12A).

3. A driving circuit for a laser light source as claimed in claim 1, wherein, when a prescribed time has elapsed in said light power measuring mode after effecting switching from said temperature measuring mode to said light power measuring mode, said selector switch (6) effects switching from said light power measuring mode to said temperature measuring mode.

4. A driving circuit for a laser light source as claimed in claim 1, wherein, as long as said first determining means determines in said temperature measuring mode that said forward voltage is smaller than said first reference voltage, said selector switch (6) continues to maintain said temperature measuring mode.

5. A driving circuit for a laser light source as claimed in claim 1, further comprising second determining means for determining whether or not said forward voltage detected by said detecting means (3) is larger than a second reference voltage which is larger than said first reference voltage, and wherein
in said temperature measuring mode, when said second determining means determines that said forward voltage is larger than said second reference voltage, said selector switch (6) effects switching from said temperature measuring mode to said light power measuring mode.

6. A driving method for a laser light source comprising a laser diode (12A) and a photodiode (12B) disposed in close proximity to said laser diode (12A) to receive light emitted from said laser diode (12A) and control the intensity of light emission of said laser diode (12A), wherein
said driving method comprises suitching with selected switch (6) between a temperature measuring mode and a light power measuring mode; wherein in said light power measuring mode, the intensity of light emission of said laser diode (12A) is controlled based on a current that said photodiode (12B) produces by receiving the light emitted from said laser diode (12A), said photodiode (12B) is forward biased by means of a constant-current source (2) in said temperature measuring mode; detecting means (3) detect the forward voltage of said photodiode (12B) in said temperature measuring mode; first determining means determine whether or not in said temperature measuring mode, when forward voltage of said photodiode (12B) being supplied with a current for forward biasing is smaller than a first reference voltage, the supply of current to said laser diode (12A) is stopped, **characterized in that** in said temperature measuring mode, when said forward voltage of said photodiode (12B) a is not smaller than said first reference voltage, the supply of current to said laser diode (12A) just before switching was effected from the power measuring mode to the temperature measuring mode is held.

7. A driving method for a laser light source, as claimed in claim 6, wherein said current supplied to said photodiode (12B) for forward biasing is sufficiently larger than the current that said photodiode (12B) produces by receiving the light emitted from said laser diode (12A). said forward voltage detected by said detecting means (3) is smeller than a first reference voltage in said temperature measuring mode; and

## Patentansprüche

1. Treiberschaltung (1) für eine Laserlichtquelle umfassend eine Laserdiode (12A) und eine Photodiode (12B), die in enger Nachbarschaft zu der Laserdiode (12A) angeordnet ist, um von der Laserdiode (12A) emittiertes Licht zu empfangen und die Intensität der Lichtemission der Laserdiode (12A) zu steuern, wobei die Treiberschaltung (1) umfasst:
Steuermittel (5) zum Steuern einer Stromversorgung für die Laserdiode (12A);
einen Wählschalter (6) zum Bewirken eines Umschaltens zwischen einem Lichtleistungsmessmodus und eines Temperaturmessmodus;
eine Konstantstromquelle (2), die in dem Temperaturmessmodus die Photodiode (12B) mit einem Strom versorgt, um die Photodiode (12B) in Durchlassrichtung vorzuspannen;
Detektionsmittel (3) zum Detektieren einer Durchlassspannung der Photodiode (12B) in dem Temperaturmessmodus;
erste Bestimmungsmittel zum Bestimmen in dem Temperaturmessmodus, ob die mittels der Detektionsmittel (3) detektierte Durchlassspannung kleiner als eine erste Referenzspannung ist oder nicht; wobei
in dem Lichtleistungsmessmodus die Steuermittel (5) die Intensität der Lichtemission der Laserdiode (12A) auf der Basis eines Stroms steuern, den die Photodiode (12B) durch Empfangen des von der Laserdiode (12A) emittierten Lichts erzeugt,
in dem Temperaturmessmodus, wenn die ersten Bestimmungsmittel bestimmen, dass die Durchlassspannung kleiner als die erste Referenzspannung ist, die Steuermittel (5) eine Steuerung ausüben, um die Stromversorgung der Laserdiode (12A) zu stoppen,
**dadurch gekennzeichnet, dass**,
in dem Temperaturmessmodus, wenn die ersten Bestimmungsmittel bestimmen, dass die Durchlassspannung nicht kleiner als die erste Referenzspannung ist, die Steuermittel (5) eine Steuerung ausüben, um die Stromversorgung der Laserdiode (12A) aufrechtzuerhalten, gerade bevor das Umschalten von dem Leistungsmessmodus zu dem Temperaturmessmodus bewirkt wurde.

2. Treiberschaltung für eine Laserlichtquelle nach Anspruch 1, wobei der Strom, mit dem die Konstantstromquelle (2) die Photodiode (12B) versorgt, ausreichend größer als der von der Photodiode (12B) durch Empfangen des von der Laserdiode (12A) emittierten Lichts erzeugte Strom ist.

3. Treiberschaltung für eine Laserlichtquelle nach Anspruch 1, wobei, wenn in dem Lichtleistungsmessmodus nach dem Bewirken eines Umschaltens von dem Temperaturmessmodus zu dem Lichtleistungsmessmodus eine vorgeschriebene Zeit abgelaufen ist, der Wählschalter (6) ein Umschalten von dem Lichtleistungsmessmodus zu dem Temperaturmessmodus bewirkt.

4. Treiberschaltung für eine Laserlichtquelle nach Anspruch 1, wobei, solange die ersten Bestimmungsmittel in dem Temperaturmessmodus bestimmen, dass die Durchlassspannung kleiner als die erste Referenzspannung ist, der Wählschalter (6) damit fortfährt, den Temperaturmessmodus aufrechtzuerhalten.

5. Treiberschaltung für eine Laserlichtquelle nach Anspruch 1, die ferner zweite Bestimmungsmittel zum Bestimmen umfasst, ob die mittels der Detektionsmittel (3) detektierte Durchlassspannung größer als die zweite Referenzspannung ist oder nicht, die größer als die erste Referenzspannung ist, und wobei
in dem Temperaturmessmodus, wenn die zweiten Bestimmungsmittel bestimmen, dass die Durchlassspannung größer als die zweite Referenzspannung ist, der Wählschalter (6) ein Umschalten von dem Temperaturmessmodus zu dem Lichtleistungsmessmodus bewirkt.

6. Ansteuerverfahren für eine Laserlichtquelle umfassend eine Laserdiode (12A) und eine Photodiode (12B), die in enger Nachbarschaft zu der Laserdiode (12A) angeordnet ist, um von der Laserdiode (12A) emittiertes Licht zu empfangen und die Intensität der Lichtemission der Laserdiode (12A) zu steuern, wobei
das Ansteuerverfahren ein Umschalten mit dem Wählschalter (6) zwischen einem Temperaturmessmodus und einem Lichtleistungsmessmodus umfasst; wobei
in dem Lichtleistungsmessmodus, die Intensität der Lichtemission der Laserdiode (12A) auf Basis eines Stroms gesteuert wird, den die Photodiode (12B) durch Empfangen des von der Laserdiode (12A) emittierten Lichts erzeugt,
die Photodiode (12B) mittels einer Konstantstromquelle (2) in dem Temperaturmessmodus in Durchlassrichtung vorgespannt ist;
Detektionsmittel (3) die Durchlassspannung der Photodiode (12B) in dem Temperaturmessmodus detektieren;
erste Bestimmungsmittel bestimmen, ob die von den Detektionsmitteln (3) detektierte Durchlassspannung kleiner als eine erste Referenzspannung in dem Temperaturmessmodus ist oder nicht; und
in dem Temperaturmessmodus, wenn die Durchlassspannung der Photodiode (12B) mit einem Strom zum Vorspannen in Durchlassrichtung versorgt wird, der kleiner als eine erste Referenzspannung ist, die Stromversorgung der Laserdiode (12A) gestoppt wird, **dadurch gekennzeichnet, dass**
in dem Temperaturmessmodus die Durchlassspannung der Photodiode (12B), wenn nicht kleiner als die erste Referenzspannung ist, die Stromversorgung der Laserdiode (12A) gerade bevor das Umschalten von dem Leistungsmessmodus zu dem Temperaturmessmodus bewirkt wurde, aufrechterhalten wird.

7. Ansteuerverfahren für eine Laserlichtquelle nach Anspruch 6, wobei der Strom, mit dem die Photodiode (12B) zum Vorspannen in Durchlassrichtung versorgt wird, ausreichend größer als der Strom ist, den die Photodiode (12B) durch Empfangen des von der Laserdiode (12A) emittierten Lichts erzeugt.

## Revendications

1. Circuit de commande (1) pour une source de lumière laser comprenant une diode laser (12A) et une photodiode (12B) disposée en étroite proximité de ladite diode laser (12A) pour recevoir une lumière émise de ladite diode laser (12A) et pour commander l'intensité de l'émission de lumière de ladite diode laser (12A), ledit circuit de commande (1) comprenant :
un moyen de commande (5) pour commander la délivrance d'un courant à ladite diode laser (12A) ;
un commutateur de sélection (6) pour effectuer une commutation entre un mode de mesure de puissance lumineuse et un mode de mesure de température ;
une source de courant constant (2) qui, dans ledit mode de mesure de température, délivre un courant à ladite photodiode (12B) de manière à polariser en sens direct ladite photodiode (12B) ;
un moyen de détection (3) pour détecter une tension directe de ladite photodiode (12B) dans ledit mode de mesure de température ;
un premier moyen de détermination pour déterminer si ladite tension directe détectée par ledit moyen de détection (3) est ou non plus petite qu'une première tension de référence dans ledit mode de mesure de température ; dans lequel
dans ledit mode de mesure de puissance lumineuse, ledit moyen de commande (5) commande l'intensité de l'émission de lumière de ladite diode laser (12A) sur la base d'un courant que ladite photodiode (12B) produit en recevant la lumière émise de ladite diode laser (12A),
dans ledit mode de mesure de température, lorsque ledit premier moyen de détermination détermine que ladite tension directe est plus petite que ladite première tension de référence, ledit moyen de commande (5) exécute une commande de manière à stopper la délivrance dudit courant à ladite diode laser (12A),
**caractérisé en ce que**,
dans ledit mode de mesure de température, lorsque ledit premier moyen de détermination détermine que ladite tension directe n'est pas plus petite que ladite première tension de référence, ledit moyen de commande (5) exécute une commande de manière à maintenir la délivrance dudit courant à ladite diode laser (12A) juste avant qu'une commutation n'eut été effectuée du mode de mesure de puissance au mode de mesure de température.

2. Circuit de commande pour une source de lumière laser selon la revendication 1, dans lequel le courant que ladite source de courant constant (2) délivre à ladite photodiode (12B) est suffisamment plus grand que le courant que ladite photodiode (12B) produit en recevant la lumière émise de ladite diode laser (12A).

3. Circuit de commande pour une source de lumière laser selon la revendication 1, dans lequel, lorsqu'une durée prescrite s'est écoulée dans ledit mode de mesure de puissance lumineuse après avoir effectué une commutation dudit mode de mesure de température audit mode de mesure de puissance lumineuse, ledit commutateur de sélection (6) effectue une commutation dudit mode de mesure de puissance lumineuse audit mode de mesure de température.

4. Circuit de commande pour une source de lumière laser selon la revendication 1, dans lequel, tant que ledit premier moyen de détermination détermine dans ledit mode de mesure de température que ladite tension directe est plus petite que ladite première tension de référence, ledit commutateur de sélection (6) continue à maintenir ledit mode de mesure de température.

5. Circuit de commande pour une source de lumière laser selon la revendication 1, comprenant en outre un deuxième moyen de détermination pour déterminer si ladite tension directe détectée par ledit moyen de détection (3) est ou non plus grande qu'une deuxième tension de référence qui est plus grande que ladite première tension de référence, et dans lequel
dans ledit mode de mesure de température, lorsque ledit deuxième moyen de détermination détermine que la tension directe est plus grande que ladite deuxième tension de référence, ledit commutateur de sélection (6) effectue une commutation dudit mode de mesure de température audit mode de mesure de puissance lumineuse.

6. Procédé de commande pour une source de lumière laser comprenant une diode laser (12A) et une photodiode (12B) disposée en étroite proximité de ladite diode laser (12A) pour recevoir une lumière émise de ladite diode laser (12A) et pour commander l'intensité de l'émission de lumière de ladite diode laser (12A), dans lequel
ledit procédé de commande comprend de commuter avec un commutateur de sélection (6) entre un mode de mesure de température et un mode de mesure de puissance lumineuse ; dans lequel
dans ledit mode de mesure de puissance lumineuse, l'intensité de l'émission de lumière de ladite diode laser (12A) est commandée sur la base d'un courant que ladite photodiode (12B) produit en recevant la lumière émise de ladite diode laser (12A),
ladite photodiode (12B) est polarisée en sens direct au moyen d'une source de courant constant (2) dans ledit mode de mesure de température ;
un moyen de détection (3) détecte la tension directe de ladite photodiode (12B) dans ledit mode de mesure de température ;
un premier moyen de détermination détermine si ladite tension directe détectée par ledit moyen de détection (3) est ou non plus petite qu'une première tension de référence dans ledit mode de mesure de température ; et
dans ledit mode de mesure de température, lorsqu'une tension directe de ladite photodiode (12B) recevant un courant pour une polarisation en sens direct est plus petite qu'une première tension de référence, la délivrance de courant à ladite diode laser (12A) est stoppée,
**caractérisé en ce que**
dans ledit mode de mesure de température, lorsque ladite tension directe de ladite photodiode (12B) n'est pas plus petite que ladite première tension de référence, la délivrance de courant à ladite diode laser (12A) juste avant que la commutation n'eut été effectuée du mode de mesure de puissance au mode de mesure de température est maintenue.

7. Procédé de commande pour une source de lumière laser, selon la revendication 6, dans lequel ledit courant délivré à ladite photodiode (12B) pour une polarisation en sens direct est suffisamment plus grand que le courant que ladite photodiode (12B) produit en recevant la lumière émise de ladite diode laser (12A).
